(19) 

Europäisches Patentamt
European Patent Office
Office européen des brevets

(11) **EP 2 933 648 B1**

(12) **EUROPEAN PATENT SPECIFICATION**

(45) Date of publication and mention
of the grant of the patent:
**20.11.2019 Bulletin 2019/47**

(21) Application number: **13865245.8**

(22) Date of filing: **02.12.2013**

(51) Int Cl.:
*G01R 31/36* (2019.01)        *H01M 10/48* (2006.01)
*G01R 31/382* (2019.01)

(86) International application number:
**PCT/JP2013/082348**

(87) International publication number:
**WO 2014/097868 (26.06.2014 Gazette 2014/26)**

(54) **PARAMETER ESTIMATING DEVICE, PARAMETER ESTIMATING METHOD, ELECTRICITY STORAGE SYSTEM, AND PROGRAM**

VORRICHTUNG ZUR PARAMETERSCHÄTZUNG, VERFAHREN ZUR PARAMETERSCHÄTZUNG, STROMSPEICHERSYSTEM UND PROGRAMM

DISPOSITIF D'ESTIMATION DE PARAMÈTRES, PROCÉDÉ D'ESTIMATION DE PARAMÈTRES, SYSTÈME DE STOCKAGE D'ÉLECTRICITÉ ET PROGRAMME

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **17.12.2012 JP 2012274750**

(43) Date of publication of application:
**21.10.2015 Bulletin 2015/43**

(73) Proprietor: **Mitsubishi Heavy Industries, Ltd.**
**Tokyo 108-8215 (JP)**

(72) Inventors:
• **WAKASUGI Kazuyuki**
  **Tokyo 108-8215 (JP)**
• **MORITA Katsuaki**
  **Tokyo 108-8215 (JP)**
• **OZAKI Kazuki**
  **Tokyo 108-8215 (JP)**
• **SHIGEMIZU Tetsuro**
  **Tokyo 108-8215 (JP)**
• **HASHIMOTO Masayuki**
  **Tokyo 108-8215 (JP)**

(74) Representative: **Hoffmann Eitle**
**Patent- und Rechtsanwälte PartmbB**
**Arabellastraße 30**
**81925 München (DE)**

(56) References cited:
EP-A1- 2 325 664         EP-A2- 1 975 635
JP-A- H0 756 608         JP-A- 2000 222 391
JP-A- 2000 222 391       JP-A- 2003 177 165
JP-A- 2010 217 079       JP-A- 2011 122 951
US-A1- 2003 158 709      US-A1- 2007 029 973
US-A1- 2012 316 812

• YI-HSIEN CHIANG ET AL: "Online estimation of internal resistance and open-circuit voltage of lithium-ion batteries in electric vehicles", JOURNAL OF POWER SOURCES, ELSEVIER SA, CH, vol. 196, no. 8, 5 January 2011 (2011-01-05), pages 3921-3932, XP028359595, ISSN: 0378-7753, DOI: 10.1016/J.JPOWSOUR.2011.01.005 [retrieved on 2011-01-14]
• MARK VERBRUGGE: "Adaptive, multi-parameter battery state estimator with optimized time-weighting factors", JOURNAL OF APPLIED ELECTROCHEMISTRY, KLUWER ACADEMIC PUBLISHERS, DO, vol. 37, no. 5, 21 February 2007 (2007-02-21), pages 605-616, XP019502122, ISSN: 1572-8838, DOI: 10.1007/S10800-007-9291-7

**Description**

Technical Field

The present invention relates to a parameter estimating device, a parameter estimating method, an electricity storage system, and a program which estimate a plurality of parameters representing the state of a device.
This application claims priority based on Japanese Patent Application No. 2012-274750, filed December 17, 2012.

Background Art

In recent years, in particular, in terms of the effective use of renewable energy, a power system/power supply system equipped with a secondary battery, such as a lithium-ion battery, has become more important. In terms of the operation and maintenance of a power system using a lithium-ion battery, the charging rate (residual capacity rate) or internal resistance (battery life) of the lithium-ion battery is required to be detected in real time during operation. However, the parameters, such as "residual capacity rate" or "life" of an electricity storage device (lithium-ion battery) described above are parameters which cannot be directly observed. Accordingly, as one method of estimating these unknown quantity groups, a parameter fitting method is known.
The parameter fitting method refers to a method in which an arbitrary (initial) estimated value is substituted in each of the unknown quantity groups and a calculated value calculated from a calculation model (actual machine simulation model or the like) prepared in advance is compared with a truth value (measured value) acquired separately to search for the truth values of the unknown quantity group. In the parameter fitting method, the error amount between the calculated values and the measured values is evaluated while gradually changing one or multiple unknown quantity groups among a plurality of unknown quantity groups to proceed in a direction in which the error amount decreases. Then, finally, an estimated value when the error has a minimum value is regarded as the truth value of the unknown quantity group.
As an evaluation function for evaluating the error amount, a method (least-squares method) using the sum of squares of an error is generally known (for example, Japanese Unexamined Patent Application Publication No. 2011-122951). In this case, in the parameter fitting method, the estimated value of the unknown quantity group is updated so as to decrease the sum of squares of the error (generally called a "hill-climbing method").

Citation List

US 2012/316812 A1 discloses a battery parameter estimating device and method as described in the preamble of the independent claims 1, 4 and 5.

Summary of Invention

Technical Problem

However, in the approach using the least-squares method, there is a case where the estimated value falls into a local solution (not the best solution but a minimum value) and does not reach a truth value in the process of changing the estimated value. In particular, when the measured value includes variation, or the like, even though the estimated value of a certain parameter is being deviated significantly from the truth value, the evaluation function value (sum of squares of error) is increased regardless of whether the estimated value is moved to increase or decrease, and the calculation ends.
This phenomenon in which the estimated value falls into the local solution can be understood ideally, for example, by changing the estimated values for all unknown quantity groups by round-robin. However, when an unknown quantity group has many independent parameters, the number of combinations becomes too large, and a calculation speed until the solution is derived is significantly decreased. Accordingly, the calculation algorithm described above is unrealistic in light of successive detection of device parameters in real time.
This case is not limited to parameter estimation, such as "residual capacity rate" or "life" in the electricity storage device, and can occur in various model cases where unknown quantities are handled.
The invention provides a parameter estimating device, a parameter estimating method, an electricity storage system, and a program which improve the estimation accuracy of device parameters to be detected without decreasing the calculation speed.

Solution to Problem

The present invention is directed to a parameter estimating device with the features of claim 1, an electricity storage system with the features of claim 4, a parameter estimating method with the features of claim 5, and a program with the features of claim 6. Preferred embodiments follow from the dependent claims.

According to a first aspect of the invention, there is provided a parameter estimating device which identifies estimated values of a plurality of parameters representing a state of a predetermined device changing according to operation. The parameter estimating device includes a state quantity measurement unit which acquires a plurality of measured values for state quantities having a correlation with the plurality of parameters at every predetermined time, a state quantity calculation unit which calculates and acquires calculated values corresponding to the plurality of measured values based on a correlation expression of the estimated values given as the plurality of parameters and the state quantities, and an optimum estimated value identification unit which finds an error evaluation function value calculated based on a value obtained by multiplying the total sum of the absolute quantities of the errors of the plurality of calculated values corresponding to the plurality of measured values by a first coefficient and a value obtained by multiplying the degree of variation of the errors by a second coefficient and executes estimated value identification processing for identifying an optimum estimated value having a minimum error evaluation function value while changing one or multiple estimated values among the estimated values. The optimum estimated value identification unit repeatedly performs the estimated value identification processing while varying the first coefficient so as to become relatively greater with respect to the second coefficient than that at the time of the execution of the previous estimated value identification processing with an optimum estimated value found in previous estimated value identification processing as an initial value.

According to a second aspect of the invention, in the parameter estimating device of the first aspect, the optimum estimated value identification unit sets both the first coefficient and the second coefficient to non-zero values during at least the initial estimated value identification processing.

According to a third aspect of the invention, in the parameter estimating device of the first or second aspect, the predetermined device is an electricity storage device equipped with a secondary battery, the state quantity is an output voltage of the electricity storage device, and the plurality of parameters are parameters representing one or both of internal resistance and a charging rate of the electricity storage device.

According to a fourth aspect of the invention, an electricity storage system includes an electricity storage device, and a parameter estimating device which identifies estimated values of a plurality of parameters representing the state of the electricity storage device changing according to operation. The parameter estimating device includes a state quantity measurement unit which acquires a plurality of measured values for an output voltage having a correlation with the plurality of parameters at every predetermined time, a state quantity calculation unit which calculates and acquires calculated values corresponding to the plurality of measured values based on a correlation expression of the estimated values given as the plurality of parameters and the output voltage, and an optimum estimated value identification unit which finds an error evaluation function value calculated based on a value obtained by multiplying the total sum of the absolute quantities of the errors of the plurality of calculated values corresponding to the plurality of measured values by a first coefficient and a value obtained by multiplying the degree of variation of the errors by a second coefficient and executes estimated value identification processing for identifying an optimum estimated value having a minimum error evaluation function value while changing one or multiple estimated values among the estimated values. The optimum estimated value identification unit repeatedly performs the estimated value identification processing while varying the first coefficient so as to become relatively greater with respect to the second coefficient than that at the time of the execution of the previous estimated value identification processing with an optimum estimated value found in previous estimated value identification processing as an initial value.

According to a fifth aspect of the invention, there is provided a parameter estimating method which identifies estimated values of a plurality of parameters representing the state of a predetermined device changing according to operation. The parameter estimating method includes acquiring a plurality of measured values for state quantities having a correlation with the plurality of parameters at every predetermined time, calculating and acquiring calculated values corresponding to the plurality of measured values based on a correlation expression of the estimated values given as the plurality of parameters and the state quantities, finding an error evaluation function value calculated based on a value obtained by multiplying the total sum of the absolute quantities of the errors of the plurality of calculated values corresponding to the plurality of measured values by a first coefficient and a value obtained by multiplying the degree of variation of the errors by a second coefficient, and repeatedly performing estimated value identification processing identifying an optimum estimated value having a minimum error evaluation function value while changing one or multiple estimated values among the estimated values while varying the first coefficient so as to become relatively greater with respect to the second coefficient than that at the time of the execution of previous estimated value identification processing with an optimum estimated value found in the previous estimated value identification processing as an initial value.

According to a sixth aspect of the invention, there is provided a program which causes a computer of a parameter estimating device, which identifies estimated values of a plurality of parameters representing the state of a predetermined device changing according to operation, to function as state quantity measurement means for acquiring a plurality of measured values for state quantities having a correlation with the plurality of parameters at every predetermined time, state quantity calculation means for calculating and acquiring calculated values corresponding to the plurality of measured values based on a correlation expression of the estimated values given as the plurality of parameters and the state quantities, and optimum estimated value identification means for finding an error evaluation function value calculated based on a value obtained by multiplying the total sum of the absolute quantities of the errors of the plurality of calculated values corresponding to the plurality of measured values by a first coefficient and a value obtained by multiplying the degree of variation of the errors by a second coefficient and executing estimated value identification processing for identifying an optimum estimated value having a minimum error evaluation function value while changing one or multiple estimated values among the estimated values. The optimum estimated value identification means further repeatedly performs the estimated value identification processing while varying the first coefficient so as to become relatively greater with respect to the second coefficient than that at the time of the execution of the previous estimated value identification processing with an optimum estimated value found in previous estimated value identification processing as an initial value.

Advantageous Effects of Invention

According to the parameter estimating device, the parameter estimating method, the electricity storage system, and the program described above, it is possible to improve the estimation accuracy of device parameters to be detected without significantly decreasing a calculation speed.

Brief Description of Drawings

Fig. 1 is a diagram showing the functional configuration of a parameter estimating device according to an embodiment of the invention.
Fig. 2 is a diagram showing an equivalent circuit of an electricity storage device according to the embodiment of the invention.
Fig. 3 is a first diagram showing the processing flow of an optimum estimated value identification unit according to the embodiment of the invention.
Fig. 4 is a second diagram showing the processing flow of the optimum estimated value identification unit according to the embodiment of the invention.
Fig. 5 is a first diagram showing comparison of a measured value and a calculated value according to the embodiment of the invention.
Fig. 6 is a second diagram showing comparison of a measured value and a calculated value according to the embodiment of the invention.
Fig. 7 is a third diagram showing comparison of a measured value and a calculated value according to the embodiment of the invention.
Fig. 8 is a diagram showing the functional configuration of an electricity storage system according to the embodiment of the invention.

Description of Embodiments

Hereinafter, a parameter estimating device according to an embodiment of the invention will be described referring to the drawings.

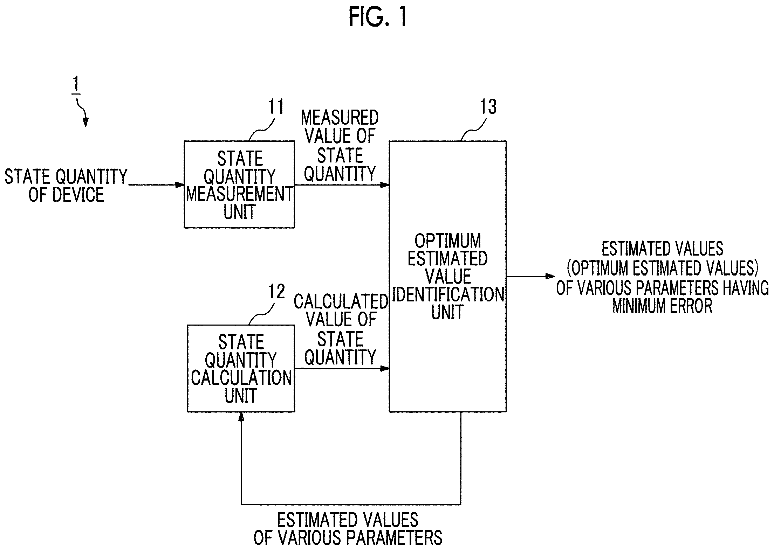

Fig. 1 is a diagram showing the functional configuration of a parameter estimating device according to the embodiment of the invention.
The parameter estimating device 1 is a device which identifies estimated values of a plurality of parameters representing the state of a predetermined device changing according to operation. In this embodiment, the "predetermined device" is, for example, an "electricity storage device". That is, the parameter estimating device 1 is a parameter estimating device which identifies estimated values of "charging rate" and "internal resistance", which cannot be directly measured, as a plurality of parameters changing according to the operation of the "electricity storage device".
The parameter estimating device 1 includes a state quantity measurement unit 11 which acquires a plurality of measured values for state quantities having a correlation with a plurality of parameters (charging rate, internal resistance, and the like) at every predetermined time. In this embodiment, the "measurable state quantity" is, for example, an "output voltage" of the electricity storage device. The state quantity measurement unit 11 of this embodiment successively measures the output voltage output from the electricity storage device in the power system. At this time, the state quantity measurement unit 11 acquires 40 plots (a period of 4 seconds) of the output voltage at every predetermined time (for example, 0.1 seconds) such that change over time in this period can be understood. As a device which acquires an output voltage as a measured value, an A/D (analog-digital) converter is usually used.

The parameter estimating device 1 includes a state quantity calculation unit 12 which calculates and acquires calculated values corresponding to a plurality of measured values acquired by the state quantity measurement unit 11 based on a correlation expression of the estimated values given as a plurality of parameters (charging rate, internal resistance, and the like) and the state quantity (output voltage). The state quantity calculation unit 12 of this embodiment holds a correlation expression of the charging rate, internal resistance, or the like and the output voltage which can be derived from a circuit model of a target electricity storage device by the parameter estimating device 1. The correlation expression is obtained by formulating change in the output voltage over time, and includes a plurality of parameters as coefficients at the time t. Accordingly, when a set of certain estimated values is given as a plurality of parameters and are substituted in the correlation expression, each value at which the output voltage according to the estimated value changes over time can be uniquely determined. The state quantity calculation unit 12 calculates and acquires calculated values (for example, having 40 plots at every 0.1 seconds) corresponding to the respective plots of a plurality of measured values acquired in the state quantity measurement unit 11. An example of a specific circuit model or a correlation expression will be described below.

The parameter estimating device 1 further includes an optimum estimated value identification unit 13 which finds an error evaluation function value calculated based on a value obtained by multiplying the total sum of the absolute quantities of the errors of a plurality of calculated values corresponding to a plurality of measured values by a first coefficient and a value obtained by multiplying the degree of variation of the errors by a second coefficient. Specifically, the optimum estimated value identification unit 13 of this embodiment first compares errors between a plurality of measured values input from the state quantity measurement unit 11 and the calculated values input from the state quantity calculation unit 12 corresponding to the measured value. The optimum estimated value identification unit 13 uses a predetermined error evaluation function (Expression (1)) as a method of comparing the errors. The optimum estimated value identification unit 13 of this embodiment is characterized in that an error evaluation function is found based on the sum of a value obtained by multiplying the total sum J of the absolute quantities of the errors by a first coefficient a1 and a value obtained by multiplying the degree σ of variation of the errors by a second coefficient a2. That is, an error evaluation function A is represented by Expression (1).

[Equation 1]

$$A = a_1 \cdot J + a_2 \cdot \sigma \qquad \cdots \quad (1)$$

The "total sum J of absolute quantities of errors" is the total sum of the error amount between a plurality of measured values plotted by the state quantity measurement unit 11 for a predetermined period and the calculated values corresponding to a plurality of measured values calculated and acquired by the state quantity calculation unit 12. That is, when the total sum J of the absolute quantities of the errors is smaller, it can be regarded that the measured values and the calculated value match each other over all plots.

The "degree σ of variation of errors" is a numerical value representing whether or not the error amount at the respective plots of the calculated values to the measured values is arranged to a constant value (for example, a value obtained by dividing the standard deviation of the errors by the average value of the errors). That is, when the degree σ of variation of the errors is small, this indicates a state in which the error amount at the respective plots is arranged to a constant value, as well as a state in which the error amount is small.

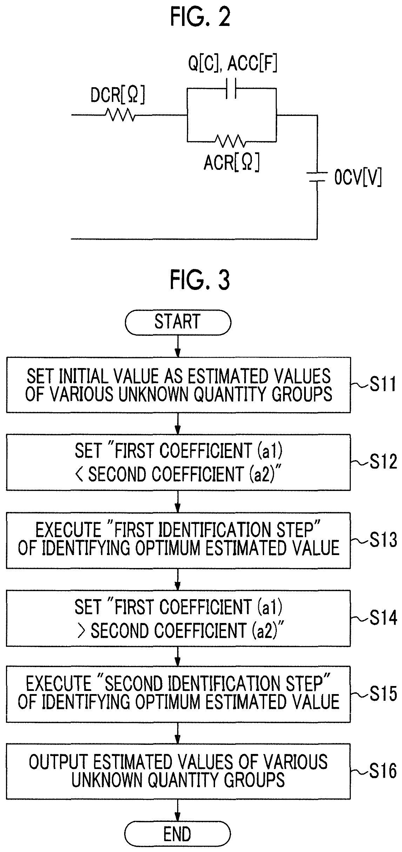

Fig. 2 is a diagram showing an equivalent circuit of an electricity storage device according to the embodiment of the invention.

Next, a circuit model and a correlation expression which are used when the state quantity calculation unit 12 of this embodiment calculates the calculated values will be specifically described.

An electrical characteristic of a general electricity storage device, such as a lithium-ion battery, is represented by a circuit diagram shown in Fig. 2. Here, DCR [Ω] of the circuit diagram shown in Fig. 2 is series internal resistance of an electricity storage device, and increases over time along with the operation of the electricity storage device. ACR [Ω] and ACC [F] are a parallel circuit of a resistor and a capacitor representing an electric double layer in an interface or the like present at each place in a battery. OCV [V] is an open-circuit voltage of the electricity storage device. A charge quantity Q [C] is a charge quantity which is stored in a capacitor ACC.

In particular, the internal resistance DCR or the open-circuit voltage OCV is an important parameter for deriving the life or the charging rate of the electricity storage device. However, all parameters representing the state of the electricity storage device cannot be directly measured, and should be calculated and indirectly derived from a different measurable state quantity (the measured value of the output voltage or change in the measured value over time). Accordingly, the state quantity calculation unit 12 of the parameter estimating device 1 of this embodiment holds a correlation expression of a plurality of parameters (DCR, ACC, ACR, OCV, and Q, and hereinafter, these are referred to as an "unknown quantity group") derived from the circuit model shown in Fig. 2 and the output voltage as a measurable state quantity. As described above, the correlation expression is obtained by formulating change in the output voltage over time, and the unknown quantity group is included in the correlation expression as coefficients at the time t. The correlation expression which is established between the unknown quantity group and the output voltage can also depend on a current value output from the electricity storage device or the temperature of the electricity storage device. Here, since the current value and the temperature can be measured, the state quantity calculation unit 12 of this embodiment may obtain a measured value of a different measurable parameter, such as a current value or a temperature, and may construct the correlation expression based on the measured value.

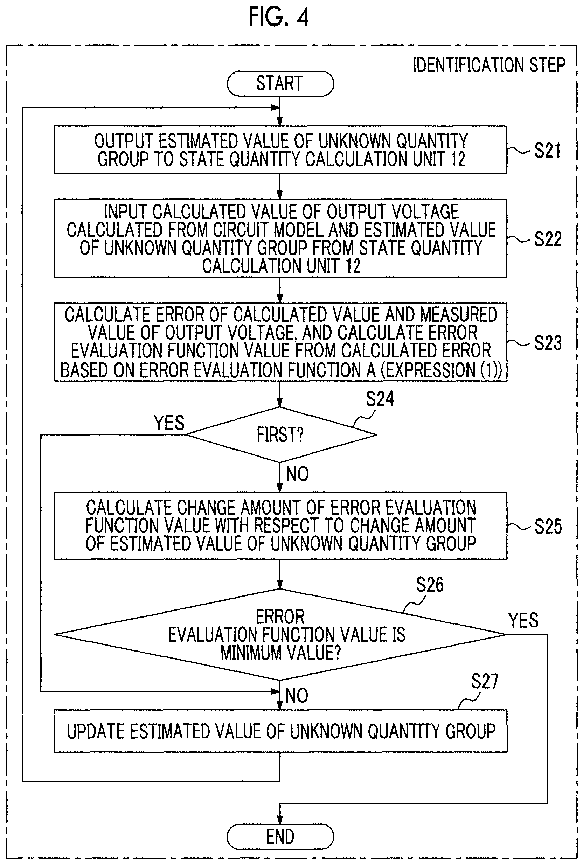

Fig. 3 is a first diagram showing the processing flow of an optimum estimated value identification unit according to the embodiment of the invention. Fig. 4 is a second diagram showing the processing flow of the optimum estimated value identification unit according to the embodiment of the invention.

The optimum estimated value identification unit 13 of this embodiment is characterized in that predetermined "estimated value identification processing" is repeatedly performed while varying the first coefficient so as to become relatively greater with respect to the second coefficient than that at the time of the execution of previous "estimated value identification processing" with an optimum estimated value found in the previous "estimated value identification processing" as an initial value. Hereinafter, the whole processing flow of the optimum estimated value identification unit 13 of this embodiment will be described in order referring to Figs. 3 and 4. As the preconditions of the processing flow in Fig. 3, the state quantity measurement unit 11 already acquires the measured value of the output voltage in the target electricity storage device, and the state quantity calculation unit 12 already acquires a predetermined correlation expression from a circuit model of the target electricity storage device and a measured value, such as a current or a temperature. A specific example of processing of Steps S13 and S15 shown in Fig. 3 is the processing flow of "estimated value identification processing" shown in Fig. 4.

First, the optimum estimated value identification unit 13 outputs appropriate estimated values as initial values of various unknown quantity groups to the state quantity calculation unit 12 (Step S11). The state quantity calculation unit 12 receives the initial estimated values and substitutes the initial estimated values given from the optimum estimated value identification unit 13 in the correlation expression to directly calculate the calculated value of the output voltage.

Next, the optimum estimated value identification unit 13 determines the values of the first coefficient a1 and the second coefficient a2 to set the error evaluation function A (Expression (1)). At this time, the optimum estimated value identification unit 13 sets the second coefficient a2 to be greater with respect to the first coefficient a1 (Step S12). This is to proceed the "estimated value identification processing" so as to increase or decrease the degree $\sigma$ of variation of the errors while focusing on the degree $\sigma$ of variation of the errors rather than the absolute quantities J of the errors in the first stage (Expression (1)). In this way, in subsequent "primary estimated value identification processing" (Step S13), the optimum estimated value identification unit 13 identifies the estimated values of the unknown quantity group such that the error amount between the measured value and the calculated value of the output voltage is arranged to a constant value over all plots (the degree $\sigma$ of variation of the errors decreases).

The optimum estimated value identification unit 13 of this embodiment executes predetermined "estimated value identification processing" (Step S13) for finding an optimum estimated value having a minimum error evaluation function value while changing one or multiple estimated values among the estimated values given as the unknown quantity group (DCR and the like). Hereinafter, a specific processing flow regarding the "estimated value identification processing" will be described in order referring to Fig. 4.

In the "primary estimated value identification processing", the optimum estimated value identification unit 13 first outputs the predetermined estimated value set or updated in the unknown quantity group in Step S11 or S27 to the state quantity calculation unit 12 (Step S21). The state quantity calculation unit 12 substitutes the estimated value given from the optimum estimated value identification unit 13 in the correlation expression acquired in advance and directly calculates the calculated value of the output voltage. However, the state quantity calculation unit 12 calculates the calculated values of the output voltage at a plurality of times from the characteristic of change in the output voltage over time determined the substituted calculation expression. The state quantity calculation unit 12 calculates the calculated values of the output voltage at a plurality of times so as to correspond to the respective plots at the respective times acquired by the state quantity measurement unit 11. Next, the optimum estimated value identification unit 13 receives the calculated values calculated by the state quantity calculation unit 12 as input (Step S22). The optimum estimated value identification unit 13 compares the measured values of the output voltage separately input from the state quantity measurement unit 11 with the calculated values, and calculates the error amount at each plot. The optimum estimated value identification unit 13 calculates the total sum J of the error amount and the degree $\sigma$ of variation of the errors from the obtained error amount at each plot and acquires an evaluation function value A1 which is found by the evaluation function A (Expression (1)) referring to the first coefficient a1 and the second coefficient a2 set in advance (Step S23).

Next, the optimum estimated value identification unit 13 determines whether or not the above processing flow is an initial (in the "estimated value identification processing", first) processing flow or a second or subsequent processing flow (Step S24). When the present processing flow is the initial processing flow, in Step S27, the estimated value of the unknown quantity group is updated, and the process returns to Step S21. When the present processing flow is the second or subsequent processing flow, the process progresses to Step S25 described below.

In the case of the second or subsequent processing flow, the optimum estimated value identification unit 13 calculates the change amount of the error evaluation function value with respect to the change amount of the estimated value of the unknown quantity group based on the error evaluation function value A1 obtained in Step S23 (Step S25). In this processing, the change amount $\Delta A$ of the error evaluation function value A1 with respect to the change amount (difference) between the estimated value updated (set) in Step S27 (or Step S11) in a previous processing flow and the estimated value newly updated in a present processing flow in the process of repeating a series of processing of Step S21 to Step S27. The optimum estimated value identification unit 13 calculates the change amount $\Delta A$, thereby determining whether or not the changed estimated value becomes close to an optimum estimated value to be found. For example, if the error evaluation function value A1 is changed to decrease, the optimum estimated value identification unit 13 can determine that the estimated value set in the present processing flow becomes closer to the optimum estimated value than the estimated value set in the previous processing flow.

Next, the optimum estimated value identification unit 13 determines whether or not the error evaluation function value A1 becomes a minimum value A1min (Step S26). A specific method for the determination will be described. In the process of changing the estimated value of the unknown quantity group, the optimum estimated value identification unit 13 detects the direction (decrease or increase) of change of the error evaluation function value A1 which changes according to the change. When the error evaluation function value A1 turns from the decreasing direction to the increasing direction in the process of changing the estimated value, the optimum estimated value identification unit 13 regards that the error evaluation function value A1 at this time is the minimum value A1min.

When it is determined in Step S26 that the error evaluation function value A1 reaches the minimum value A1min, the optimum estimated value identification unit 13 regards that the estimated value from which the minimum value A1min is derived is an optimum estimated value and ends the "estimated value identification processing". When the error evaluation function value A1 does not reach the minimum value A1min, optimum estimated value identification unit 13 gives a new change amount to the estimated value used in the present processing flow to update the estimated value (Step S27). At this time, in Step S25, when the change amount $\Delta A$ of the error evaluation function value decreases, the estimated value is updated to an estimated value changed by a predetermined change amount in the same direction as change of the estimated value causing the change amount $\Delta A$. When the change amount $\Delta A$ increases, the estimated value is updated to an estimated value changed in a direction opposite to change of the estimated value causing the change amount $\Delta A$. In this way, each time a series of processing of Step S21 to Step S27 is repeated, the minimum value A1min of the error evaluation function can become close to the optimum estimated value to be calculated (however, the initial processing flow is excluded). The optimum estimated value identification unit 13 outputs the thus-updated estimated value to the state quantity calculation unit 12 (Step S21), and repeatedly executes the processing flow after Step S22.

The optimum estimated value identification unit 13 identifies an optimum estimated value which derives the minimum value A1min of the error evaluation function A based on the "estimated value identification processing" described above. In this way, the optimum estimated value identification unit 13 can identify an optimum estimated value which gives the minimum value A1min with a minimum number of processing.

Meanwhile, the processing flow described above assumes that the minimum value A1min of the error evaluation function A is searched while changing one estimated value. However, actually, the optimum estimated value identification unit 13 should identify an optimum estimated value while changing the estimated values of a plurality of unknown quantity groups. Accordingly, for example, the optimum estimated value identification unit 13 of this embodiment may further perform the following processing. That is, in Step S26, the optimum estimated value identification unit 13 prepares sets of estimated values changed significantly focusing on one of a plurality of estimated values for each of a plurality of unknown quantity groups. In Step S24, a set of estimated values of an unknown quantity group which brings the greatest change amount in the error evaluation function value A1 among the sets of estimated values is used, and then the following processing flow is executed.

For example, it is assumed that there are three unknown quantity groups of "DCR, ACC, ACR". At this time, in Step S26, the optimum estimated value identification unit 13 prepares three estimated value sets of "DCR2A, ACC2, ACR2", "DCR2, ACC2A, ACR2", and "DCR2, ACC2, ACR2A" in the second processing flow with respect to the estimated values "DCR1, ACC1, ACR1" of the unknown quantity group used in the first processing flow. It is assumed that the change amount of DCR2A with respect to DCR1 is greater than the change amount of DCR2 with respect to DCR1, and the change amount of ACC2A with respect to ACC1 is greater than the change amount of ACC2 with respect to ACC1. Similarly, it is assumed that the change amount of ACR2A with respect to ACR1 is greater than the change amount of ACR2 with respect to ACR1.

Subsequently, in Step S24, the optimum estimated value identification unit 13 derives three error evaluation function values A21, A22, and A23 obtained based on the three estimated value sets. An estimated value set most significantly changed from the error evaluation function value A1 derived in the first processing flow is selected among these sets, and the estimated values are further updated based on the set of estimated values from which the error evaluation function value is calculated (Step S27).

In this way, the optimum estimated value identification unit 13 can reduce the number of repetitions until the optimum estimated value is reached. The processing flow described below is an example only, and in this embodiment, various other means capable of attaining the same object may be used.

If the processing regarding the "primary estimated value identification processing" (Fig. 4) ends, the optimum estimated value identification unit 13 obtains an optimum estimated value of an unknown quantity group for deriving the minimum value of the error evaluation function A. As described above, in the "primary estimated value identification processing" (Step S13), the optimum estimated value identification unit 13 identifies the estimated values of the unknown quantity group such that the error amount between the measured values and the calculated values of the output voltage is arranged to a constant value over all plots (the degree $\sigma$ of variation of the errors decreases). Estimation processing performed in Step S13 will be described referring to graphs.

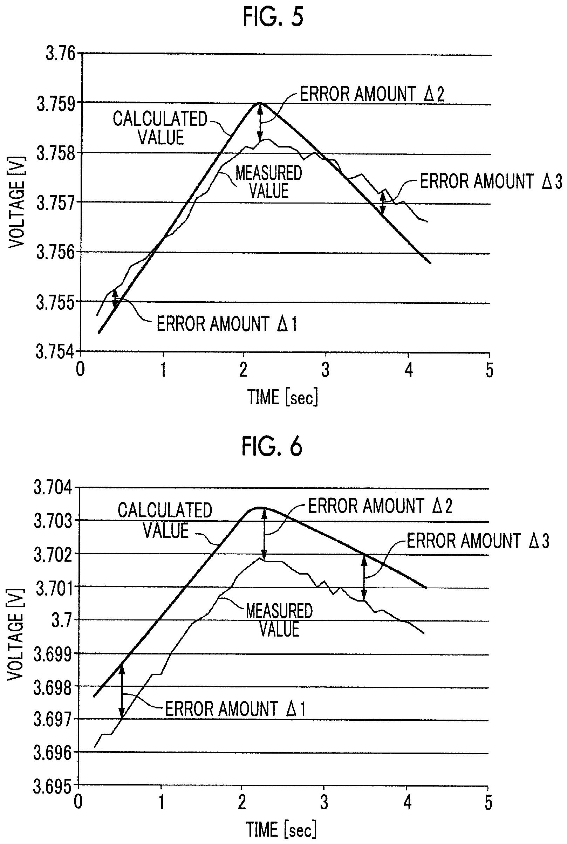

Fig. 5 is a first diagram showing comparison of a measured value and a calculated value according to the embodiment of the invention.

First, the graph of the measured value shown in Fig. 5 is plotted by the state quantity measurement unit 11 which measures the output voltage in the target electricity storage device before the processing flow shown in Fig. 3 starts. The graph of the calculated value shown in Fig. 5 is plotted by the state quantity calculation unit 12 which calculates change in the output voltage over time calculated based on the initial value given from the optimum estimated value identification unit 13 in Step S11. As shown in Fig. 5, at the beginning (Step S11), the measured value and the calculated value of the output voltage do not match other other, and it can be read that estimated values do not reflect the parameters of the actual electricity storage device. For example, in the graph of the calculated value shown in Fig. 5, for example, the magnitude and the sign (plus or minus) of error amount $\Delta 1$, $\Delta 2$, and A3 at three plots do not match one another.

Fig. 6 is a second diagram showing comparison of a measured value and a calculated value according to the embodiment of the invention.

Accordingly, the parameter estimating device 1 of this embodiment first identifies an estimated value having a minimum degree $\sigma$ of variation of the errors focusing on the degree $\sigma$ of variation of the errors between the measured values and the calculated values at the respective plots.

That is, the optimum estimated value identification unit 13 of this embodiment can identify the optimum estimated value of the unknown quantity group for deriving the graph of the calculated value shown in Fig. 6 by the "primary estimated value identification processing" (Steps S12 to S13 of Fig. 3) for reducing the degree $\sigma$ of variation of the error. In the graph of the calculated value shown in Fig. 6, it can be read that the magnitude and the sign of the error amount $\Delta 1$, $\Delta 2$, and $\Delta 3$ at the three plots substantially match one another are read. However, in the "primary estimated value identification processing", since the processing proceeds not so as to positively reduce the total sum J of the error amount, the absolute quantities of the errors ($\Delta 1$, $\Delta 2$, $\Delta 3$) from the measured values are comparatively great.

As described above, the optimum estimated value identification unit 13 identifies the optimum estimated value having a minimum degree $\sigma$ of variation of the errors based on the error evaluation function A set by the coefficients a1 and a2 set in Step S12 in the "primary estimated value identification processing". In at least the initial "estimated value identification processing", the optimum estimated value identification unit 13 may set both of the first coefficient a1 and the second coefficient a2 to non-zero values. That is, even in the "primary estimated value identification processing" for decreasing the degree $\sigma$ of variation of the errors, the optimum estimated value identification unit 13 does not set the first coefficient a1 multiplied to the absolute quantities J of the errors to zero and considers the first coefficient a1 as a part of the error evaluation function A. This considers a problem that, if the error evaluation function A is constituted only by the degree $\sigma$ of variation of the errors, when the measured value and the calculated value are too different from each other, the estimated value is increasingly likely to fall into a local solution in subsequent "secondary estimated value identification processing", and the minimum value of the degree $\sigma$ of variation is not correctly obtained. Even in the "primary estimated value identification processing", the optimum estimated value identification unit 13 functions to reduce the total sum J of the absolute quantities of the errors. Accordingly, even when the measured value and the calculated value are significantly different from each other, the minimum value of the degree $\sigma$ of variation can be accurately obtained.

The description of a subsequent processing flow of the optimum estimated value identification unit 13 will be continued referring to Fig. 3 again.

In Step S13, if the optimum estimated value having a minimum degree $\sigma$ of variation of the errors is identified, next, the optimum estimated value identification unit 13 sets the respective coefficients such that the first coefficient a1 becomes relatively greater with respect to the second coefficient a2 (Step S14). This is because, in a subsequent processing flow, the second "estimated value identification processing" proceeds so as to reduce the absolute quantities J of the errors. In this way, in the subsequent "secondary estimated value identification processing" (Step S15), the optimum estimated value identification unit 13 identifies the estimated values of the unknown quantity group such that the error amount between the measured values and the calculated values of the output voltage is reduced over all plots (the total sum J of the absolute quantities of the errors decreases).

Specific processing of the "secondary estimated value identification processing" is the same as the "primary estimated value identification processing" shown in Fig. 4. However, as described above, in the "secondary estimated value identification processing" (Step S15), the optimum estimated value identification unit 13 identifies the estimated values of the unknown quantity group such that the error amount between the measured values and the calculated values of the output voltage becomes minimum over all plots (the total sum J of the absolute quantities of the errors decreases). Estimation processing performed in Step S15 will be specifically described referring to graphs.

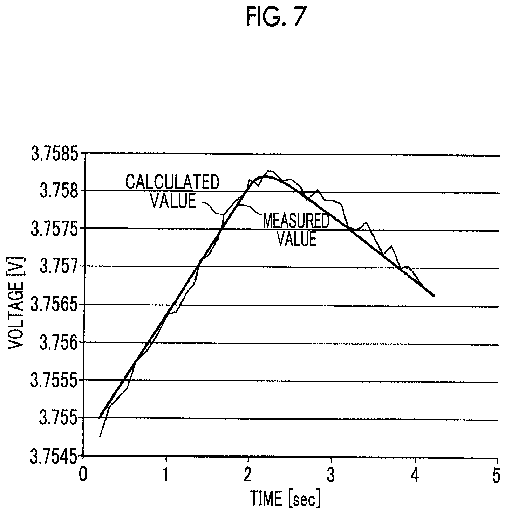

Fig. 7 a third diagram showing comparison of a measured value and a calculated value according to the embodiment of the invention.

The optimum estimated value identification unit 13 of this embodiment identifies an optimum estimated value which derives the graphs shown in Fig. 7 by the "secondary estimated value identification processing" (Steps S14 to S15 of Fig. 3) for reducing the total sum J of the error amount subsequent to the "primary estimated value identification processing" for reducing the degree $\sigma$ of variation of the errors. The graph of the calculated value shown in Fig. 7 substantially matches the graph of the measured value. Accordingly, the optimum estimated value identification unit 13 executes the "secondary estimated value identification processing" for reducing the total sum J of the absolute quantities of the errors after the "primary estimated value identification processing" for reducing the degree $\sigma$ of variation of the errors shown in Fig. 6, whereby the estimated values having high estimation accuracy regarding the electricity storage device can be obtained.

The optimum estimated value identification unit 13 outputs the optimum estimated value obtained in the "secondary estimated value identification processing" of Step S15 (Step S16). The parameter estimating device 1 displays the optimum estimated value finally output from the optimum estimated value identification unit 13 in a form such that an operator of the electricity storage device can visually recognize the optimum estimated value. With this, the operator of the electricity storage device can understand the state (life, charging rate, and the like) of the electricity storage device in real time. The parameter estimating device 1 may acquire the measured value, for example, for every 1 minute (for 4 seconds) and may repeatedly output an optimum estimated value based on the measured value. In this way, the operator can understand deterioration of the electricity storage device over time or change in the charging rate referring to the parameters output at an interval of 1 minute.

The effects of the parameter estimating device 1 of this embodiment will be described while comparing with a general parameter fitting method.

If the "estimated value identification processing" described referring to Fig. 4 is performed based on a parameter fitting method (simply, only the total sum J of the absolute quantities of the errors by a least-squares method is included in an error evaluation function) of the related art, a correct solution may not be obtained due to a noise component or the like of the measured value. The optimum estimated value identification unit 13 stops the processing when the minimum value of the total sum J of the absolute quantities of the errors is detected. Accordingly, the determination regarding whether or not a correct solution (the minimum value of J) is obtained tends to significantly depends on the initial values of the unknown quantity group. That is, when an estimated value is searched in order to simply reduce the total sum J of the absolute quantities of the errors, in many cases, there may be a plurality of minimum values in this process, the estimated value falls into an unintended minimum value, and the calculation ends.

The parameter estimating device 1 of this embodiment attempts to obtain the minimum value of the degree $\sigma$ of variation of the errors in the "primary estimated value identification processing". In this case, the total sum J of the absolution quantities of the errors is not substantially considered, and calculation is performed simply by arranging the inclinations of both graphs (Fig. 6). Accordingly, there are no plurality of minimum values in the calculation process (primary estimated value identification processing). Therefore, there are few cases where the estimated value falls into an unintended minimum value and the calculation ends.

After the estimated value having a minimum degree $\sigma$ of variation of the errors is obtained (after the inclinations of both graphs are arranged), when the "secondary estimated value identification processing" for searching for the minimum value of the total sum J of the absolute quantities of the errors is executed, the error amount which is present equally between the respective plots of the measured value and the calculated value only becomes zero (the positions of both graphs of Fig. 6 are arranged). Therefore, there are no plurality of unintended minimum values in this process.

According to the parameter estimating device 1 of this embodiment, it is possible to improve the estimation accuracy of device parameters to be detected without significantly decreasing a calculation speed.

In the processing flow of the optimum estimated value identification unit 13 of this embodiment described referring to Fig. 3, although an example where the "estimated value identification processing" is performed twice has been described, this embodiment is not limited thereto. That is, the optimum estimated value identification unit 13 may repeatedly perform the "estimated value identification processing" more than three times. However, in the process of repeating the "estimated value identification processing", the optimum estimated value identification unit 13 repeatedly performs the "estimated value identification processing" while varying the first coefficient a1 so as to become relatively greater with respect to the second coefficient a2 than that at the time of the execution of previous "estimated value identification processing" with an optimum estimated value found in the previous "estimated value identification processing" as an initial value.

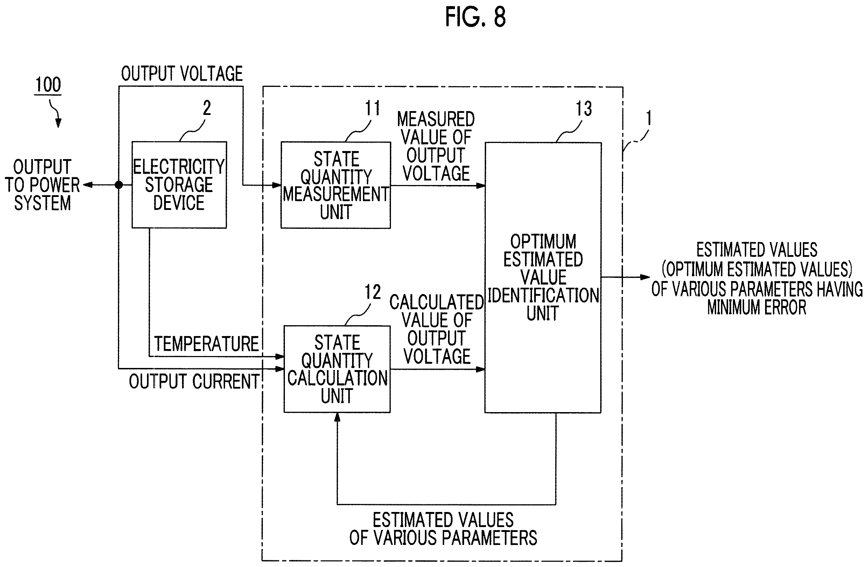

Fig. 8 is a diagram showing the functional configuration of an electricity storage system according to the embodiment of the invention.

Herein, an electricity storage system 100 in which the parameter estimating device 1 described above and an electricity storage device to be monitored are integrated will be described. The electricity storage system 100 includes the parameter estimating device 1 described above and an electricity storage device 2. The electricity storage device 2 is equipped with a secondary battery, such as a lithium-ion battery. In the electricity storage system 100 of this embodiment, the state quantity measurement unit 11 of the parameter estimating device 1 acquires an output voltage value output from the electricity storage device 2 to a predetermined power system. The state quantity calculation unit 12 acquires a correlation expression based on a circuit model of the electricity storage device 2 and a measured value, such as temperature or an output current. The function of the optimum estimated value identification unit 13 is as described above, finds an error amount between the calculated value calculated based on the correlation expression by the state quantity calculation unit 12 and the measured value acquired by the state quantity measurement unit 11, and finally calculates and outputs an optimum estimated value. In this embodiment, as shown in Fig. 8, the parameter estimating device 1 may be integrated with the electricity storage device 2 to be monitored to construct the electricity storage system 100.

In the above description, although an example where the parameter estimating device 1 of this embodiment has an electricity storage device as the "predetermined device" has been described, this embodiment is not limited thereto. For example, the invention can be applied to a case of detecting armature resistance and magnetic flux of a permanent magnet synchronous motor. In this case, measurable state quantities are a voltage, a current, an angular velocity, and the like when the motor is driven, and parameters which change according to the operation of the motor are, for example, armature resistance, magnetic flux, and the like.

The parameter estimating device 1 described above includes a computer system therein. The operations of respective processing of the parameter estimating device 1 described above are stored in a computer-readable recording medium in the form of a program, and a computer reads and executes this program, thereby performing the above processing. Herein, the computer-readable recording medium refers to a magnetic disk, a magneto-optical disk, a CD-ROM, a DVD-ROM, a semiconductor memory, or the like. In addition, this computer program may be distributed to a computer through a communication line, and the computer which undergoes the distribution may execute this program.

While certain embodiments have been described, these embodiments have been presented by way of example only, and are not intended to limit the scope of the invention. Indeed, these embodiments may be embodied in a variety of other forms; furthermore, various omissions, substitutions and changes in the form of the embodiments may be made within the scope of the invention, which is defined by the appended claims.

Industrial Applicability

According to the parameter estimating device, the parameter estimating method, the electricity storage system, and the program described above, it is possible to improve the estimation accuracy of device parameters to be detected without significantly decreasing a calculation speed.

Reference Signs List

1:     parameter estimating device
11:    state quantity measurement unit
12:    state quantity calculation unit
13:    optimum estimated value identification unit
2:     electricity storage device
100:   electricity storage system

**Claims**

1. A parameter estimating device (1) for identifying estimated values of a plurality of parameters representing a state of a predetermined device changing according to operation, the parameter estimating device comprising:

a state quantity measurement unit (11) adapted to measure and acquire a plurality of measured values for state quantities having a correlation with the plurality of parameters at every predetermined time;

a state quantity calculation unit (12) adapted to acquire initial estimated values and to calculate calculated values corresponding to the plurality of measured values by substituting said initial estimated values given as the plurality of parameters in a correlation expression of the estimated values and the state quantities; and

an optimum estimated value identification unit (13) which is adapted to output the initial estimated values to the state quantity calculation unit (12) and to repeatedly obtain, while changing at least one of the estimated values, an error evaluation function value calculated by summing a value obtained by multiplying the total sum of the absolute quantities of the errors of the plurality of calculated values corresponding to the plurality of measured values by a first coefficient (a1) and a value obtained by multiplying a value obtained by dividing the standard deviation of the errors by the average value of the errors by a second coefficient (a2) and executes estimated value identification processing for identifying an optimum estimated value having a minimum error evaluation function value,

**characterized in that** the optimum estimated value identification unit (13) is adapted to repeatedly execute the estimated value identification processing in which the first coefficient (a1) is set relatively greater with respect to the second coefficient (a2), with an optimum estimated value identified by the estimated value identification processing in which the second coefficient (a2) is set relatively greater with respect to the first coefficient (a1) as an initial value.

2. The parameter estimating device (1) according to claim 1,
   wherein the optimum estimated value identification unit (13) is adapted to set both the first coefficient (a1) and the second coefficient (a2) to non-zero values during at least the initial estimated value identification processing.

3. The parameter estimating device (1) according to claim 1 or 2,
   wherein the predetermined device is an electricity storage device (2) equipped with a secondary battery,
   the state quantity is an output voltage of the electricity storage device (2), and
   the plurality of parameters are parameters representing one or both of internal resistance and a charging rate of the electricity storage device (2).

4. An electricity storage system (100) comprising:

   an electricity storage device (2); and
   a parameter estimating device (1) for identifying estimated values of a plurality of parameters representing the state of the electricity storage device (2) changing according to operation,
   wherein the parameter estimating device (1) includes
   a state quantity measurement unit (11) adapted to measure and acquire a plurality of measured values for an output voltage having a correlation with the plurality of parameters at every predetermined time,
   a state quantity calculation unit (12) adapted to acquire initial estimated values and to calculate calculated values corresponding to the plurality of measured values by substituting said initial estimated values given as the plurality of parameters in a correlation expression of the estimated values and the output voltage, and
   an optimum estimated value identification unit (13) which is adapted to output the initial estimated values to the state quantity calculation unit (12) and to repeatedly obtain, while changing at least one of the estimated values, an error evaluation function value calculated by summing a value obtained by multiplying the total sum of the absolute quantities of the errors of the plurality of calculated values corresponding to the plurality of measured values by a first coefficient (a1) and a value obtained by multiplying a value obtained by dividing the standard deviation of the errors by the average value of the errors by a second coefficient (a2) and executes estimated value identification processing for identifying an optimum estimated value having a minimum error evaluation function value, and
   **characterized in that** the optimum estimated value identification unit (13) is adapted to repeatedly execute the estimated value identification processing in which the first coefficient (a1) is set relatively greater with respect to the second coefficient (a2), with an optimum estimated value identified by the estimated value identification processing in which the second coefficient (a2) is set relatively greater with respect to the first coefficient (a1) as an initial value.

5. A parameter estimating method of identifying estimated values of a plurality of parameters representing the state of a predetermined device changing according to operation, the parameter estimating method comprising:

   a state quantity measuring step of measuring and acquiring a plurality of measured values for state quantities having a correlation with the plurality of parameters at every predetermined time; and

a state quantity calculating step of acquiring initial estimated values and calculating calculated values corresponding to the plurality of measured values by substituting said initial estimated values given as the plurality of parameters in a correlation expression of the estimated values and the state quantities;

an optimum estimated value identifying step (S13, S14) of repeatedly obtaining, while changing at least one of the estimated values, an error evaluation function value calculated by summing a value obtained by multiplying the total sum of the absolute quantities of the errors of the plurality of calculated values corresponding to the plurality of measured values by a first coefficient (a1) and a value obtained by multiplying a value obtained by dividing the standard deviation of the errors by the average value of the errors by a second coefficient (a2) and executing estimated value identification processing for identifying an optimum estimated value having a minimum error evaluation function value,

**characterized in that** the optimum estimated value identifying step comprises:

a first optimum estimated value identifying step (S13) of executing the estimated value identification processing in which the second coefficient (a2) is set relatively greater with respect to the first coefficient (a1); and a second optimum estimated value identifying step (S14) of executing the estimated value identification processing in which the second coefficient (a2) is set relatively greater with respect to the first coefficient (a1), with an optimum estimated value identified by the first optimum estimated value identifying step as an initial value.

6. A computer program comprising software code which, when executed on a computer of a parameter estimating device, which identifies estimated values of a plurality of parameters representing the state of a predetermined device changing according to operation, is adapted to perform the following steps:

a state quantity measuring step of acquiring a plurality of measured values for state quantities having a correlation with the plurality of parameters at every predetermined time;

a state quantity calculating step of acquiring initial estimated values and calculating calculated values corresponding to the plurality of measured values based on a correlation expression of said initial estimated values given as the plurality of parameters and the state quantities; and

an optimum estimated value identifying step (S13, S14) of repeatedly obtaining, while changing at least one of the estimated values, an error evaluation function value calculated by summing a value obtained by multiplying the total sum of the absolute quantities of the errors of the plurality of calculated values corresponding to the plurality of measured values by a first coefficient (a1) and a value obtained by multiplying a value obtained by dividing the standard deviation of the errors by the average value of the errors by a second coefficient (a2) and executing estimated value identification processing for identifying an optimum estimated value having a minimum error evaluation function value,

**characterized in that** the optimum estimated value identifying step (S13, S14) comprises:

a first optimum estimated value identifying step (S13) of executing the estimated value identification processing in which the second coefficient (a2) is set relatively greater with respect to the first coefficient (a1); and a second optimum estimated value identifying step (S14) of executing the estimated value identification processing in which the second coefficient (a2) is set relatively greater with respect to the first coefficient (a1), with an optimum estimated value identified by the first optimum estimated value identifying step as an initial value.

**Patentansprüche**

1. Vorrichtung (1) zur Parameterschätzung zum Identifizieren geschätzter Werte einer Vielzahl von Parametern, die einen Zustand einer vorbestimmten Vorrichtung darstellen, die sich gemäß Betrieb verändern, wobei die Vorrichtung zur Parameterschätzung umfasst:

eine Zustandsquantitätsmessungseinheit (11), die angepasst ist, eine Vielzahl von gemessenen Werten für Zustandsquantitäten zu messen und zu beschaffen, die eine Korrelation mit der Vielzahl von Parametern zu jeder vorbestimmten Zeit aufweisen;

eine Zustandsquantitätsberechnungseinheit (12), die angepasst ist, geschätzte Anfangswerte zu beschaffen und berechnete Werte entsprechend der Vielzahl von gemessenen Werten durch Ersetzen der geschätzten Anfangswerte, die als die Vielzahl von Parametern gegeben sind, in einem Korrelationsausdruck der geschätzten Werte und der Zustandsquantitäten zu berechnen; und

eine Identifizierungseinheit (13) für einen geschätzten optimalen Wert, die angepasst ist, die geschätzten Anfangswerte an die Zustandsquantitätsberechnungseinheit (12) auszugeben und wiederholt während eines Änderns mindestens eines der geschätzten Werte einen Fehlerevaluierungsfunktionswert zu erhalten, der durch Summieren eines Werts, der durch Multiplizieren der Gesamtsumme der absoluten Quantitäten der Fehler der Vielzahl von berechneten Werten entsprechend der Vielzahl von gemessenen Werten mit einem ersten Koeffizienten (a1) erhalten wird, und eines Werts, der durch Multiplizieren eines Werts, der durch Dividieren der Standardabweichung der Fehler durch den Durchschnittswert der Fehler erhalten wird, mit einem zweiten Koeffizienten (a2) erhalten wird, und Identifizierungsverarbeitung eines geschätzten Werts zum Identifizieren eines geschätzten optimalen Werts ausführt, der einen minimalen Fehlerevaluierungsfunktionswert aufweist,

**dadurch gekennzeichnet, dass** die Identifizierungseinheit (13) für einen geschätzten optimalen Wert angepasst ist, die Identifizierungsverarbeitung eines geschätzten Wertes, bei der der erste Koeffizient (a1) relativ größer gegenüber dem zweiten Koeffizienten (a2) eingestellt ist, wiederholt mit einem geschätzten optimalen Wert auszuführen, der durch die Identifizierungsverarbeitung von einem geschätzten Wert identifiziert ist, bei der der zweite Koeffizient (a2) relativ größer gegenüber dem ersten Koeffizienten (a1) als ein Anfangswert eingestellt ist.

2. Vorrichtung (1) zur Parameterschätzung nach Anspruch 1,
wobei die Identifizierungseinheit (13) von einem geschätzten optimalen Wert angepasst ist, um beide, den ersten Koeffizienten (a1) und den zweiten Koeffizienten (a2) während mindestens der Identifizierungsverarbeitung von einem geschätzten Anfangswert auf Nicht-Null-Werte einzustellen.

3. Vorrichtung (1) zur Parameterschätzung nach Anspruch 1 oder 2,
wobei die vorbestimmte Vorrichtung eine Stromspeichervorrichtung (2) ist, die mit einer Sekundärbatterie ausgestattet ist,
die Zustandsquantität eine Ausgangsspannung der Stromspeichervorrichtung (2) ist und
die Vielzahl von Parametern Parameter sind, die eines oder beides von innerem Widerstand und einer Laderate der Stromspeichervorrichtung (2) darstellen.

4. Stromspeichersystem (100), umfassend:

eine Stromspeichervorrichtung (2); und
eine Vorrichtung (1) zur Parameterschätzung zum Identifizieren von geschätzten Werten einer Vielzahl von Parametern, die den Zustand der Stromspeichervorrichtung (2) darstellen, der sich gemäß Betrieb verändert, wobei die Vorrichtung (1) zur Parameterschätzung beinhaltet
eine Zustandsquantitätsmessungseinheit (11), die angepasst ist, eine Vielzahl von gemessenen Werten für eine Ausgangsspannung zu messen und zu beschaffen, die eine Korrelation mit der Vielzahl von Parametern zu jeder vorbestimmten Zeit aufweisen,
eine Zustandsquantitätsberechnungseinheit (12), die angepasst ist, geschätzte Anfangswerte zu beschaffen und berechnete Werte entsprechend der Vielzahl von gemessenen Werten durch Ersetzen der geschätzten Anfangswerte, die als die Vielzahl von Parametern gegeben sind, in einem Korrelationsausdruck der geschätzten Werte und der Ausgangsspannung zu berechnen, und
eine Identifizierungseinheit (13) für geschätzte optimale Werte, die angepasst ist, die geschätzten Anfangswerte an die Zustandsquantitätsberechnungseinheit (12) auszugeben und wiederholt während eines Änderns mindestens eines der geschätzten Werte einen Fehlerevaluierungsfunktionswert zu erhalten, der durch Summieren eines Werts, der durch Multiplizieren der Gesamtsumme der absoluten Quantitäten der Fehler der Vielzahl von berechneten Werten entsprechend der Vielzahl von gemessenen Werten mit einem ersten Koeffizienten (a1) erhalten wird, und eines Werts, der durch Multiplizieren eines Werts, der durch Dividieren der Standardabweichung der Fehler durch den Durchschnittswert der Fehler erhalten wird, mit einem zweiten Koeffizienten (a2) erhalten wird, und Identifizierungsverarbeitung von einem geschätzten Wert zum Identifizieren eines geschätzten optimalen Werts ausführt, der einen minimalen Fehlerevaluierungsfunktionswert aufweist, und
**dadurch gekennzeichnet, dass** die Identifizierungseinheit (13) für einen geschätzten optimalen Wert angepasst ist, die Identifizierungsverarbeitung von einem geschätzten Wert, in der der erste Koeffizient (a1) relativ größer gegenüber dem zweiten Koeffizienten (a2) eingestellt ist, wiederholt mit einem geschätzten optimalen Wert auszuführen, der durch die Identifizierungsverarbeitung von einem geschätzten Wert identifiziert ist, in der der zweite Koeffizient (a2) relativ größer gegenüber dem ersten Koeffizienten (a1) als ein Anfangswert eingestellt ist.

5. Verfahren zur Parameterschätzung zum Identifizieren geschätzter Werte einer Vielzahl von Parametern, die den Zustand einer vorbestimmten Vorrichtung darstellen, der sich gemäß Betrieb ändert, wobei das Verfahren zur Parameterschätzung umfasst:

einen Zustandsquantitätsmessungsschritt zum Messen und Beschaffen einer Vielzahl von gemessenen Werten für Zustandsquantitäten, die eine Korrelation mit der Vielzahl von Parametern zu jeder vorbestimmten Zeit aufweisen; und

einen Zustandsquantitätsberechnungsschritt zum Beschaffen von geschätzten Anfangswerten und Berechnen von berechneten Werten entsprechend der Vielzahl von gemessenen Werten durch Ersetzen der geschätzten Anfangswerte, die als die Vielzahl von Parametern gegeben sind, in einem Korrelationsausdruck der geschätzten Werte und der Zustandsquantitäten;

einen Identifizierungsschritt (S13, S14) von einem geschätzten optimalen Wert zum wiederholtem Erhalten, während mindestens einer der geschätzten Werte geändert wird, eines Fehlerevaluierungsfunktionswerts, der erhalten wird durch Summieren eines Werts, der durch Multiplizieren der Gesamtsumme der absoluten Quantitäten der Fehler der Vielzahl von berechneten Werten entsprechend der Vielzahl von gemessenen Werten mit einem ersten Koeffizienten (a1) erhalten wird, und eines Werts, der durch Multiplizieren eines Werts, der durch Dividieren der Standardabweichung der Fehler durch den Durchschnittswert der Fehler erhalten wird, mit einem zweiten Koeffizienten (a2) erhalten wird, und Ausführen von Identifizierungsverarbeitung von einem geschätzten Wert zum Identifizieren eines geschätzten optimalen Werts, der einen minimalen Fehlerevaluierungsfunktionswert aufweist,

**dadurch gekennzeichnet, dass** der Identifizierungsschritt von einem geschätzten optimalen Wert umfasst:

einen ersten Identifizierungsschritt (S13) von einem geschätzten optimalen Wert zum Ausführen der Identifizierungsverarbeitung von einem geschätzten Wert, in der der zweite Koeffizient (a2) relativ größer gegenüber dem ersten Koeffizienten (a1) eingestellt ist; und

einen zweiten Identifizierungsschritt (S14) von einem geschätzten optimalen Wert zum Ausführen der Identifizierungsverarbeitung von einem geschätzten Wert, in der der zweite Koeffizient (a2) relativ größer gegenüber dem ersten Koeffizienten (a1) eingestellt ist, mit einem geschätzten optimalen Wert, der durch den Identifizierungsschritt von einem geschätzten optimalen Wert als ein Anfangswert identifiziert ist.

6. Computerprogramm, umfassend einen Softwarecode, der, wenn auf einem Computer einer Vorrichtung zur Parameterschätzung ausgeführt wird, die geschätzte Werte einer Vielzahl von Parametern identifiziert, die den Zustand einer vorbestimmten Vorrichtung darstellen, der sich gemäß Betrieb ändert, angepasst ist, die folgenden Schritte durchzuführen:

einen Zustandsquantitätsmessungsschritt zum Beschaffen einer Vielzahl von gemessenen Werten für Zustandsquantitäten, die eine Korrelation mit der Vielzahl von Parametern zu jeder vorbestimmten Zeit aufweisen;

einen Zustandsquantitätsberechnungsschritt zum Beschaffen von geschätzten Anfangswerten und Berechnen berechneter Werte entsprechend der Vielzahl von gemessenen Werten, basierend auf einem Korrelationsausdruck der geschätzten Anfangswerte, die als die Vielzahl von Parametern gegeben sind, und den Zustandsquantitäten; und

einen Identifizierungsschritt (S13, S14) von einem geschätzten optimalen Wert zum wiederholten Erhalten, während eines Änderns mindestens eines der geschätzten Werte, eines Fehlerevaluierungsfunktionswerts, der berechnet wird durch Summieren eines Werts, der durch Multiplizieren der Gesamtsumme der absoluten Quantitäten der Fehler der Vielzahl von berechneten Werten entsprechend der Vielzahl von gemessenen Werten mit einem ersten Koeffizienten (a1) erhalten wird, und eines Werts, der durch Multiplizieren eines Werts, der durch Dividieren der Standardabweichung der Fehler durch den Durchschnittswert der Fehler erhalten wird, mit einem zweiten Koeffizienten (a2) erhalten wird, und Ausführen von Identifizierungsverarbeitung von einem geschätzten Wert zum Identifizieren eines geschätzten optimalen Werts, der einen minimalen Fehlerevaluierungsfunktionswert aufweist,

**dadurch gekennzeichnet, dass** der Identifizierungsschritt (S13, S14) von einem geschätzten optimalen Wert umfasst:

einen ersten Identifizierungsschritt (S13) von einem geschätzten optimalen Wert zum Ausführen der Identifizierungsverarbeitung von einem geschätzten Wert, in der der zweite Koeffizient (a2) relativ größer gegenüber dem ersten Koeffizienten (a1) eingestellt ist; und

einen zweiten Identifizierungsschritt (S14) von einem geschätzten optimalen Wert zum Ausführen der Identifizierungsverarbeitung von einem geschätzten Wert, in der der zweite Koeffizient (a2) relativ größer gegenüber dem ersten Koeffizienten (a1) eingestellt ist, mit einem geschätzten optimalen Wert, der durch den Identifizierungsschritt von einem geschätzten optimalen Wert als ein Anfangswert identifiziert ist.

**Revendications**

1. Dispositif d'estimation de paramètre (1) pour identifier des valeurs estimées d'une pluralité de paramètres représentant un état d'un dispositif prédéterminé changeant en fonction d'un fonctionnement, le dispositif d'estimation de paramètre comprenant :

   une unité de mesure de quantité d'état (11) adaptée pour mesurer et acquérir une pluralité de valeurs mesurées pour des quantités d'état ayant une corrélation avec la pluralité de paramètres à chaque temps prédéterminé ;
   une unité de calcul de quantité d'état (12) adaptée pour acquérir des valeurs estimées initiales et pour calculer des valeurs calculées correspondant à la pluralité de valeurs mesurées en substituant lesdites valeurs estimées initiales données en tant que la pluralité de paramètres dans une expression de corrélation des valeurs estimées et des quantités d'état ; et
   une unité d'identification de valeur estimée optimale (13) qui est adaptée pour délivrer les valeurs estimées initiales à l'unité de calcul de quantité d'état (12) et pour obtenir à plusieurs reprises, tout en changeant au moins l'une des valeurs estimées, une valeur de fonction d'évaluation d'erreur calculée en faisant la somme d'une valeur obtenue en multipliant la somme totale des quantités absolues des erreurs de la pluralité de valeurs calculées correspondant à la pluralité de valeurs mesurées par un premier coefficient (a1) et d'une valeur obtenue en multipliant une valeur obtenue en divisant l'écart-type des erreurs par la valeur moyenne des erreurs par un second coefficient (a2) et exécute un traitement d'identification de valeur estimée pour identifier une valeur estimée optimale présentant une valeur de fonction d'évaluation d'erreur minimale,
   **caractérisé en ce que** l'unité d'identification de valeur estimée optimale (13) est adaptée pour exécuter à plusieurs reprises le traitement d'identification de valeur estimée dans lequel le premier coefficient (a1) est fixé pour être relativement plus élevé par rapport au second coefficient (a2), avec une valeur estimée optimale identifiée par le traitement d'identification de valeur estimée dans lequel le second coefficient (a2) est fixé pour être relativement plus élevé par rapport au premier coefficient (a1) en tant que valeur initiale.

2. Dispositif d'estimation de paramètre (1) selon la revendication 1,
   dans lequel l'unité d'identification de valeur estimée optimale (13) est adaptée pour fixer à la fois le premier coefficient (a1) et le second coefficient (a2) à des valeurs non nulles pendant au moins le traitement d'identification de valeur estimée initiale.

3. Dispositif d'estimation de paramètre (1) selon la revendication 1 ou 2,
   dans lequel le dispositif prédéterminé est un dispositif de stockage d'électricité (2) équipé d'une batterie secondaire,
   la quantité d'état est une tension de sortie du dispositif de stockage d'électricité (2), et
   la pluralité de paramètres sont des paramètres représentant un ou les deux parmi une résistance interne et un taux de charge du dispositif de stockage d'électricité (2).

4. Système de stockage d'électricité (100) comprenant :

   un dispositif de stockage d'électricité (2) ; et
   un dispositif d'estimation de paramètre (1) pour identifier des valeurs estimées d'une pluralité de paramètres représentant un état du dispositif de stockage d'électricité (2) changeant en fonction d'un fonctionnement,
   dans lequel le dispositif d'estimation de paramètre (1) inclut
   une unité de mesure de quantité d'état (11) adaptée pour mesurer et acquérir une pluralité de valeurs mesurées pour une tension de sortie ayant une corrélation avec la pluralité de paramètres à chaque temps prédéterminé,
   une unité de calcul de quantité d'état (12) adaptée pour acquérir des valeurs estimées initiales et pour calculer des valeurs calculées correspondant à la pluralité de valeurs mesurées en substituant lesdites valeurs estimées initiales données en tant que la pluralité de paramètres dans une expression de corrélation des valeurs estimées et de la tension de sortie, et
   une unité d'identification de valeur estimée optimale (13) qui est adaptée pour délivrer les valeurs estimées initiales à l'unité de calcul de quantité d'état (12) et pour obtenir à plusieurs reprises, tout en changeant au moins l'une des valeurs estimées, une valeur de fonction d'évaluation d'erreur calculée en faisant la somme d'une valeur obtenue en multipliant la somme totale des quantités absolues des erreurs de la pluralité de valeurs calculées correspondant à la pluralité de valeurs mesurées par un premier coefficient (a1) et d'une valeur obtenue en multipliant une valeur obtenue en divisant l'écart-type des erreurs par la valeur moyenne des erreurs par un second coefficient (a2) et exécute un traitement d'identification de valeur estimée pour identifier une valeur estimée optimale présentant une valeur de fonction d'évaluation d'erreur minimale, et **caractérisé en ce que** l'unité d'identification de valeur estimée optimale (13) est adaptée pour exécuter à plusieurs reprises le traitement d'identification de valeur estimée dans lequel le premier coefficient (a1) est fixé pour être relativement plus élevé par rapport au second coefficient (a2), avec une valeur estimée optimale identifiée par le traitement d'identification de valeur estimée dans lequel le second coefficient (a2) est fixé pour être relativement plus élevé par rapport au premier coefficient (a1) en tant que valeur initiale.

5. Procédé d'estimation de paramètre pour identifier des valeurs estimées d'une pluralité de paramètres représentant l'état d'un dispositif prédéterminé changeant en fonction d'un fonctionnement, le procédé d'estimation de paramètre comprenant :

   une étape de mesure de quantité d'état pour mesurer et acquérir une pluralité de valeurs mesurées pour des quantités d'état ayant une corrélation avec la pluralité de paramètres à chaque temps prédéterminé ; et
   une étape de calcul de quantité d'état pour acquérir des valeurs estimées initiales et calculer des valeurs calculées correspondant à la pluralité de valeurs mesurées en substituant lesdites valeurs estimées initiales données en tant que la pluralité de paramètres dans une expression de corrélation des valeurs estimées et des quantités d'état ;
   une étape d'identification de valeur estimée optimale (S13, S14) pour obtenir à plusieurs reprises, tout en changeant au moins l'une des valeurs estimées, une valeur de fonction d'évaluation d'erreur calculée en faisant la somme d'une valeur obtenue en multipliant la somme totale des quantités absolues des erreurs de la pluralité de valeurs calculées correspondant à la pluralité de valeurs mesurées par un premier coefficient (a1) et d'une valeur obtenue en multipliant une valeur obtenue en divisant l'écart-type des erreurs par la valeur moyenne des erreurs par un second coefficient (a2) et exécuter un traitement d'identification de valeur estimée pour identifier une valeur estimée optimale présentant une valeur de fonction d'évaluation d'erreur minimale, **caractérisé en ce que** l'étape d'identification de valeur estimée optimale comprend :

      une première étape d'identification de valeur estimée optimale (S13) pour exécuter le traitement d'identification de valeur estimée dans lequel le second coefficient (a2) est fixé pour être relativement plus élevé par rapport au premier coefficient (a1) ; et
      une seconde étape d'identification de valeur estimée optimale (S14) pour exécuter le traitement d'identification de valeur estimée dans lequel le second coefficient (a2) est fixé pour être relativement plus élevé par rapport au premier coefficient (a1), avec une valeur estimée optimale identifiée par la première étape d'identification de valeur estimée optimale en tant que valeur initiale.

6. Programme informatique comprenant un code de logiciel qui, quand il est exécuté sur un ordinateur d'un dispositif d'estimation de paramètres, qui identifie des valeurs estimées d'une pluralité de paramètres représentant l'état d'un dispositif prédéterminé changeant en fonction d'un fonctionnement, est adapté pour mettre en œuvre les étapes suivantes :

   une étape de mesure de quantité d'état pour acquérir une pluralité de valeurs mesurées pour des quantités d'état ayant une corrélation avec la pluralité de paramètres à chaque temps prédéterminé ;
   une étape de calcul de quantité d'état pour acquérir des valeurs estimées initiales et calculer des valeurs calculées correspondant à la pluralité de valeurs mesurées sur la base d'une expression de corrélation desdites valeurs estimées initiales données en tant que la pluralité de paramètres et des quantités d'état ; et
   une étape d'identification de valeur estimée optimale (S13, S14) pour obtenir à plusieurs reprises, tout en changeant au moins l'une des valeurs estimées, une valeur de fonction d'évaluation d'erreur calculée en faisant la somme d'une valeur obtenue en multipliant la somme totale des quantités absolues des erreurs de la pluralité de valeurs calculées correspondant à la pluralité de valeurs mesurées par un premier coefficient (a1) et d'une valeur obtenue en multipliant une valeur obtenue en divisant l'écart-type des erreurs par la valeur moyenne des erreurs par un second coefficient (a2) et exécuter un traitement d'identification de valeur estimée pour identifier une valeur estimée optimale présentant une valeur de fonction d'évaluation d'erreur minimale, **caractérisé en ce que** l'étape d'identification de valeur estimée optimale (S13, S14) comprend :

      une première étape d'identification de valeur estimée optimale (S13) pour exécuter le traitement d'identification de valeur estimée dans lequel le second coefficient (a2) est fixé pour être relativement plus élevé par rapport au premier coefficient (a1) ; et
      une seconde étape d'identification de valeur estimée optimale (S14) pour exécuter le traitement d'identification de valeur estimée dans lequel le second coefficient (a2) est fixé pour être relativement plus élevé par rapport au premier coefficient (a1), avec une valeur estimée optimale identifiée par la première étape d'identification de valeur estimée optimale en tant que valeur initiale.

# FIG. 1

EP 2 933 648 B1

## FIG. 2

## FIG. 3

START

SET INITIAL VALUE AS ESTIMATED VALUES
OF VARIOUS UNKNOWN QUANTITY GROUPS ~S11

SET "FIRST COEFFICIENT (a1)
< SECOND COEFFICIENT (a2)" ~S12

EXECUTE "FIRST IDENTIFICATION STEP"
OF IDENTIFYING OPTIMUM ESTIMATED VALUE ~S13

SET "FIRST COEFFICIENT (a1)
> SECOND COEFFICIENT (a2)" ~S14

EXECUTE "SECOND IDENTIFICATION STEP"
OF IDENTIFYING OPTIMUM ESTIMATED VALUE ~S15

OUTPUT ESTIMATED VALUES OF VARIOUS
UNKNOWN QUANTITY GROUPS ~S16

END

## FIG. 4

IDENTIFICATION STEP

START

OUTPUT ESTIMATED VALUE OF UNKNOWN QUANTITY GROUP TO STATE QUANTITY CALCULATION UNIT 12 — S21

INPUT CALCULATED VALUE OF OUTPUT VOLTAGE CALCULATED FROM CIRCUIT MODEL AND ESTIMATED VALUE OF UNKNOWN QUANTITY GROUP FROM STATE QUANTITY CALCULATION UNIT 12 — S22

CALCULATE ERROR OF CALCULATED VALUE AND MEASURED VALUE OF OUTPUT VOLTAGE, AND CALCULATE ERROR EVALUATION FUNCTION VALUE FROM CALCULATED ERROR BASED ON ERROR EVALUATION FUNCTION A (EXPRESSION (1)) — S23

S24 FIRST? — YES / NO

CALCULATE CHANGE AMOUNT OF ERROR EVALUATION FUNCTION VALUE WITH RESPECT TO CHANGE AMOUNT OF ESTIMATED VALUE OF UNKNOWN QUANTITY GROUP — S25

S26 ERROR EVALUATION FUNCTION VALUE IS MINIMUM VALUE? — YES / NO

UPDATE ESTIMATED VALUE OF UNKNOWN QUANTITY GROUP — S27

END

## FIG. 5

## FIG. 6

FIG. 7

## FIG. 8

EP 2 933 648 B1

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2012274750 A
- JP 2011122951 A
- US 2012316812 A1